# EUROPEAN PATENT APPLICATION

(11) **EP 1 724 838 A1**
(43) Date of publication of application: **22.11.2006**
(21) Application number: 05405350.9
(22) Date of filing: 17.05.2005
(51) Int. Cl.: H01L 27/30, H01L 31/068, H01L 31/072, H01G 9/20

(54) **Tandem photovoltaic conversion device**

(71) Applicant: ECOLE POLYTECHNIQUE FEDERALE DE LAUSANNE, 1015 Lausanne (CH)
(72) Inventor: Graetzel, Michael, 1025 St-Sulpice (CH); Liska, Paul, 1018 Lausanne (CH); Thampi, Ravindranathan K., 1023 Crissier (CH); Comte, Pascal, 1350 Orbe (CH)
(74) Representative: Ganguillet, Cyril

(57) **Abstract**

The tandem photovoltaic conversion device comprises at least one top photovoltaic cell unit and one bottom photovoltaic cell unit laminated along a light transmitting direction and electrically connected, wherein said top cell unit is a dye sensitised or semiconductor nanoparticle solar cell and wherein said bottom cell unit is selected among p-n junction semiconductor based cells.

## Description

The present invention relates to a photovoltaic device for generating electricity when it is illuminated by a light source like sunlight, and which may be stacked in a tandem arrangement.

Since the invention of the p-n junction photovoltaic cell, conventional solar cells, mainly in silicon, but also made of other semiconductors, have used this approach for enhancing the overall conversion efficiency.

Many photovoltaic devices currently use a single crystal or amorphous silicon. Document WO 04/084282 discloses a bifacial solar cell with two thin-film polycrystalline or amorphous Si cells formed on opposite sides of a transparent substrate. However, cells produced in this manner are expensive, if a large size is required.

A further type of photovoltaic device, which has been developed is the thin-film semiconductor solar cell, for example, the cadmium telluride/cadmium sulphide solar cell. Polycrystalline cadmium telluride/cadmium sulphide solar cells are one of the most important types of photovoltaic devices which provide a more cost-effective generation of solar electricity. Document GB 2405030 teaches to stack at least two devices of this kind, provided with different dopants, to gather more radiation at different wavelengths.

Document JP 20002368238 discloses a tandem solar cell comprising a group III - V compound semiconductor upper cell laminated above a group IV semiconductor lower cell. The document WO 2005/020334 discloses a system including an Si cell sandwiched between a AlGaAs cell and a Ge cell. However, the costs of these devices is extremely high, limiting their use.

The technical progress in nanocrystalline TiO₂ based Dye sensitized Solar Cells (DSC) has come a long way since the breakthrough findings were first reported during the early 1990s, for example in US 4,927,721. Today, DSCs are available both as liquid junction cells and hole-conductor based solid-state cells. In addition, cells containing quasi-solid electrolytes with molten salts, polymers and gels have been reported, for example in EP 737358.

DSCs are available in different colours and opacities, so they can replace windows and facades in buildings and other structures.

Despite the easy fabrication methods, DSCs currently suffer from some engineering challenges, such as sealing methods and the prevention of electrolyte loss. Liquid junction DSCs have reached > 11% energy conversion efficiencies, whereas their solid-state equivalents using hole-conductors have exceeded 4% efficiency. The attainment of 11% conversion efficiency (h) is the result of using a highly purified N-719 dye along with self-assembly facilitating agents. But it would be very difficult to achieve efficiencies much beyond 11% with the standard N-719 sensitizer, unless the redox system in the electrolyte is also changed. Alternatively, if the present iodide based redox system is maintained, introducing panchromatic sensitizers can boost the efficiency of cells further. To give 15% conversion efficiency, these should be designed to yield at least 24 mA/cm² short circuit current density (Isc) under full sunlight and fill factor (FF) as well as open circuit voltage (Voc) similar to those that are presently obtained. However, attaining such a high Isc together with good Voc and FF is not easy when considering the limitations in the solubility of new panchromatic dyes and their extinction coefficients. The use of porphyrin type chromophores also did not meet with success. The limitations in going for higher TiO₂ layer thickness should also be taken into account.

Therefore, other methods capable to improve the spectral window available to DSCs should also be considered. It is possible to extend the available spectral window to IR wavelengths by operating DSCs in a tandem mode. Such an approach may improve the Voc and the immediate task will then be limited to retaining Isc between 15 and 20 mA/cm², and FF ≥ 0.7. The concept of a tandem DSC device has been disclosed by document US 6,310,282, and by document EP 1513171, the latter using the red dye N3 for the top cell and a black dye for the bottom cell. An efficiency of 10.5% with ISC = 21.1 mA/cm² has been achieved in this manner. However, the device relied on panchromatic dyes, which do not absorb beyond 800 nm and hence with only a limited sucess above the already obtained 11% value using a single DSC. Ideally,a tandem device incorporating two DSC cells should make use in the top cell of a first dye exhibiting a high absorption at short wavelengths, and substantially no absorption at long wavelengths, and make use in the bottom cell containing a second dye, exhibiting high absorption at longer wavelengths, especially in the infrared. Unfortunately, such optimized sets of dyes are not presently available.

Thus, a target of the present invention is to provide another device structure involving DSC's with improved utilization of the available spectral windows.

Thus, an object of the present invention is a tandem photovoltaic conversion device, comprising at least one top photovoltaic cell unit and one bottom photovoltaic cell unit laminated along a light transmitting direction and electrically connected, wherein the said top cell unit is a dye sensitized solar cell or a semiconductor light harvesting nanoparticle solar cell, and wherein the said bottom cell unit is selected among p-n junction semiconductor based cells.

The top photovoltaic cell unit may comprise a first transparent, electrically conducting electrode layer, a transparent porous layer of semiconducting materiel comprised of nanoparticles, a monolayer of sensitising dye adsorbed on said nanoparticles, a first transparent counter-electrode, and a charge transport layer sandwiched between said porous layer and said counter-electrode.

This charge transport layer may be selected among liquid,solid and quasi-solid, in particular quasi-solid gel electrolytes, it penetrates at least partially said porous layer and comprises a redox couple, of which the reducing species is capable of regenerating said dye.

The bottom cell unit may be selected among amorphous Si cells and crystalline Si cells.

According to a preferred embodiment, said bottom cell unit is selected among thin-film n-type semiconductor/p-type semiconductor cells. Said n-type semiconductor and/or said p-type semiconductor may be selected among group III, IV or V compounds.

According to a particularly preferred embodiment, said bottom cell unit is a copper - indium selenide or copper indium gallium selenide cell (referred as CIS and CIGS cells, respectively).

According to a further, preferred embodiment, said bottom cell unit further comprises a sensitising semiconductor at an interface between said n-type and said p-type semiconductors.

According to a further preferred embodiment, said n-type semiconductor is made of finelly divided and sintered large band gap ceramic oxide particles, and said sensitising semiconductor is in form of quantum dots absorbed on said ceramic oxide particles, forming a bulk heterojunction. Cells of this type are disclosed in applicants patent application EP 1176646, the content of which is incorporated herein by reference. A specific advantage of quantum dots, is that their absorption spectra may be tuned by tuning their particle sizes.

Also, said p-type semiconductor may be selected among reversibly oxidisable amorphous organic compounds and polymers.

In the top cell unit, the sensitising dye may be selected among dyes substantially absorbing no light above 650-700 nm, but exhibiting a strong absorption band with an absorption coefficient at λₘₐₓ of at least 5'000, and preferably at least 13'000 1·cm⁻¹·M⁻¹, at peak wavelengths in this range, whereas the bottom cell is designed for harvesting light above 700 nm, preferably within a wavelength range of at least 200 nm width.

A specifically preferred device is a device wherein the bottom cell is sensitised by Quantum dots, wherein the sensitising dye of the top cell unit is selected among dyes having a transparency window within the wavelength range 350 - 700 nm, between two absorption bands, and wherein said Quantum dots of said bottom cell unit are selected among Quantum dots capable of multiple carrier generation, that is to say multiple exciton generation upon absorption of one photon having a wavelength within said transparency window.

Further, features and advantages of the devices according to the invention will appear to those skilled in the art from the following description of two exemplary embodiments in connection with the drawings.

### Brief description of the figures:

- Figure 1: Schema of classical DSC (Figure 1A) and Tandem Cell concept (Figure 1B). The tandem arrangement depicts a visible light absorbing top DSC (1) generating 0.85 V with 2 bottom DSCs (2a & 2b) absorbing IR wavelengths, all in series connection. The bottom cells generate 1.2 V. The mean short circuit current will be around 15 mA/cm² and the fill factor, 0.7. The total yield will be ≥ 20%;

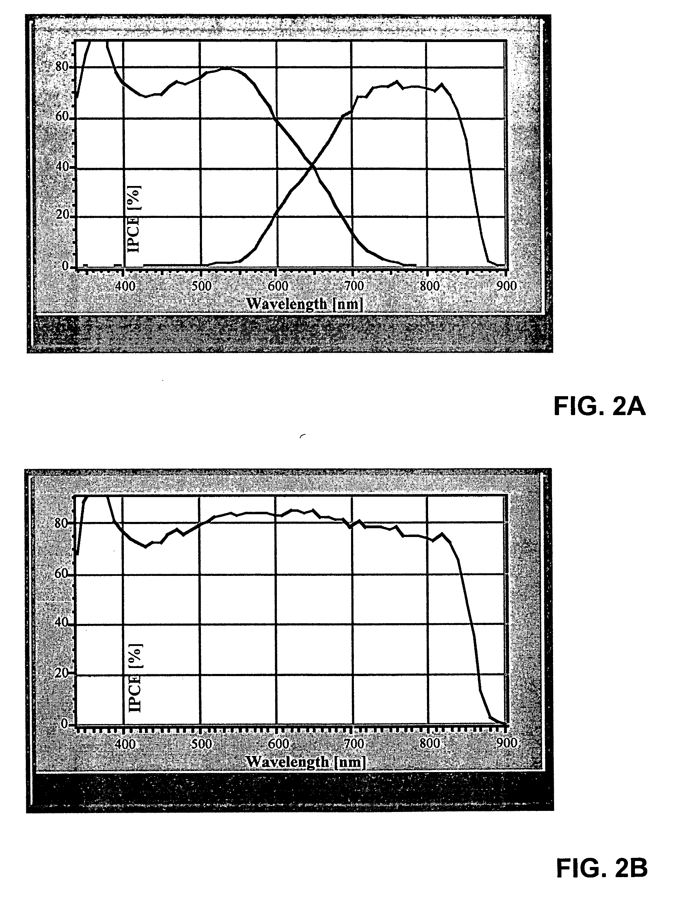

- Figure 2: Individual spectral responses of the top and bottom cells (Figure 2A) and the combined envelope of the tandem device (Figure 2B); the spectra of the bottom device, in this case, is obtained by using a thin-film CIGS solar cells;
- Figure 3A: Incident Photon to Current Conversion Efficiency (IPCE) of DSC, CIGS and the combined system, when arranged as per the device scheme shown in figure 1;
- Figure 3B: Absorbed solar photon flux (AM 1.5 global) by the DSC top cell and the CIGS bottom cell in the tandem device;
- Figure 4: I-V curve of a tandem device using DSC as the top cell. The bottom cells are made of silicon. The device size is 1.6 cm². Values for isc, Voc, ff and overall efficiency are 10.16 mA/cm², 2.01 V, 0.737 and 15.05%. The electrical connection is as shown in figure 1.

### Example 1:

The top DSC (A rectangular cell with 1.6 cm² active area) was fabricated using the standard N-719 dye with an Electrolyte containing 0.6 M butyl methyl imidazolium iodide, 0.03 M iodine, 0.5 M tertiary-butyl pyridine and 0.1 M guanidinium thiocyanate in 85:15 mixture of acetonitrile and valeronitrile. Details of fabrication of such cells have been reported (M.K. Nazeeruddin, P. Pechy, T. Renouard, S.M. Zakeeruddin, R. Humphry-Baker, P. Comte, P. Liska, L. Cevey, E. Costa, V. Shklover, L. Spiccia, G.B. Deacon, C.A. Bignozzi and M. Graetzel, J. American Chemical Society, 123, 1613-1624 (2001)). The CIS cell at the bottom has been procured from other laboratories and fabricated as described in A. Romeo, M. Terheggen, D. Abou-Ras, D.L. Bätzner, F.-J. Haug, M. Kälin, D. Rudmann, A.N. Tiwari, 'Development of thin-film Cu(In,Ga)Se2 and CdTe solar cells', Progress in Photovoltaics: Research and Applications 12 (2004) 93-111 and M. Kaelin, D. Rudmann, A.N. Tiwari, 'Low cost processing of CIGS thin film solar cells', Solar Energy 77 (2004) 749-756, and references therein.

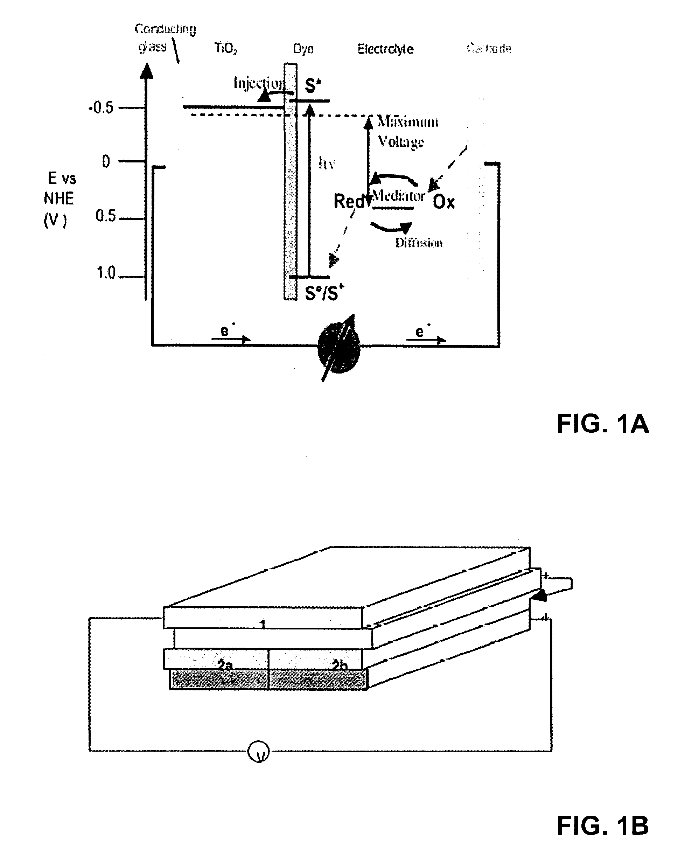

The top and bottom cells have been placed one over the other as shown in figure 1B and connected in series. An antireflective layer has been applied over the top cell to improve the yield. A Xenon solar simulator has been used at various intensities with appropriate spectral corrections. Details of the test set-up have been reported (M.K. Nazeeruddin, P. Pechy, T. Renouard, S.M. Zakeeruddin, R. Humphry-Baker, P. Comte, P. Liska, L. Cevey, E. Costa, V. Shklover, L. Spiccia, G.B. Deacon, C.A. Bignozzi and M. Graetzel, J. American Chemical Society, 123, 1613-1624 (2001)) .

The top cell configuration shall be such that it achieves at least 8% conversion efficiency using a dye sensitized mesoscopic TiO₂ film that is transparent in the wavelength domain above 700-750 nm.

The bottom cell is in series connected to the top cell. In such a configuration it has to generate at least the same photocurrent as the top cell (15 mA/cm²) using the solar light that passes through the top layer, i.e. photons with longer wavelength than 700-750 nm. In the embodiment, which is presently disclosed the onset of the photocurrent for CIGS is at 1'230 nm and the cell delivers an open circuit voltage of 0.55 V. The CIGS cell generates a short circuit photocurrent of ca 36 mA/cm² of which more than half arises from wavelength above 700 nm. Hence the 15 mA/cm² generated in the top cell is readily sustained by the CIGS bottom layer. In series connection, the two systems together produce an open circuit voltage of at least 1.35 V, For obtaining 15% conversion efficiency, a fill factor of 0.74 is required.

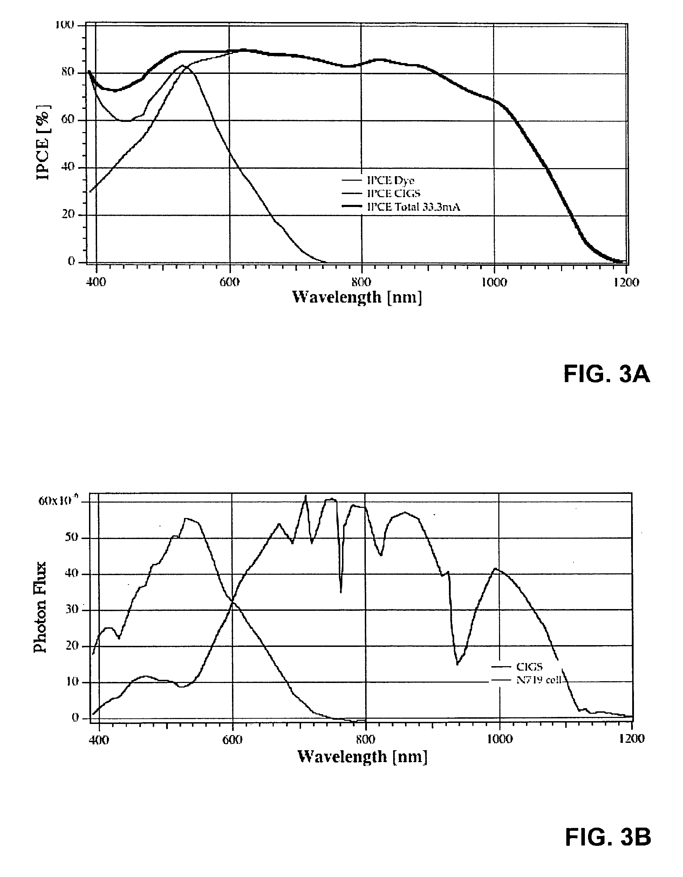

Figure 3A shows the IPCE characteristics of (a) the top DSC, (b) the bottom CIGS cell and (c) the tandem device at 1.5 AM white light.

### Example 2:

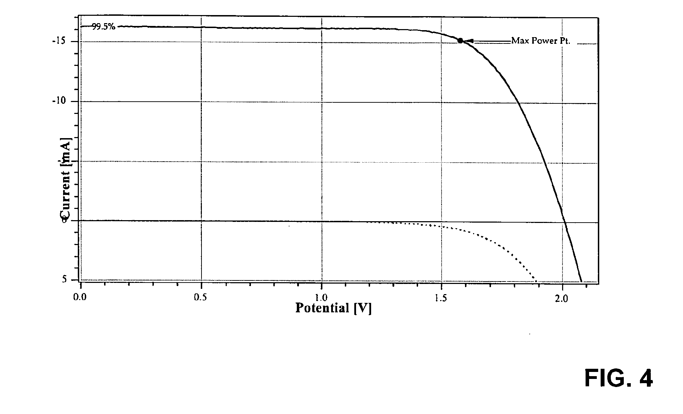

Figure 4 shows the I-V characteristics of a tandem device embodiment built up as shown in Figure 1, where the top cell is a DSC as described in example 1 and the bottom cells are Silicon cells instead of CIGS cells.

## Claims

1. A tandem photovoltaic conversion device, comprising at least one top photovoltaic cell unit and one bottom photovoltaic cell unit laminated along a light transmitting direction and electrically connected, wherein said top cell unit is a dye sensitised or semiconductor nanoparticle solar cell and wherein said bottom cell unit is selected among p-n junction semiconductor based cells.

2. A device according to claim 1, wherein said top solar cell comprises
- a first transparent, electrically conducting electrode layer,
- a transparent porous layer of semiconducting material comprised of nanoparticles,
- a monolayer of a sensitising dye adsorbed on said nanoparticles,
- or a layer of semiconductor nanoparticles acting as light harvesters,
- a first transparent counterelectrode, and
- a charge transport layer sandwiched between said porous layer and said counter electrode.

3. A device according to claim 2, wherein said charge transport layer is selected among liquid, solid, and quasi-solid, in particular quasi-solid gel electrolytes, ionic liquids, hole conductors, penetrating at least partially said porous layer and comprises a redox couple, of which the reducing species is capable of regenerating said dye.

4. A device according to anyone of the preceding claims, wherein said bottom cell unit is selected among amorphous Si cells and crystalline Si cells.

5. A device according to anyone of claims 1-3, wherein said bottom cell unit is selected among thin-film n-type semiconductor/p-type semiconductor cells.

6. A device according to claim 5, wherein said n-type semiconductor and/or said p-type semiconductor is selected among group III, IV or V compounds.

7. A device according to claim 5, wherein said bottom cell unit is a copper - indium selenide or copper indium gallium selenide cell.

8. A device according to claim 5, wherein said bottom cell unit further comprises a sensitising semiconductor at an interface between said n-type and said p-type semiconductors.

9. A device according to claim 8, wherein said n-type semiconductor is made of finelly divided and sintered large band gap ceramic oxide particles and wherein said sensitising semiconductor is in form of quantum dots adsorbed on said oxide particles.

10. A device according to claim 9, wherein said p-type semiconductor is selected among reversibly oxidisable amorphous organic compounds and polymers.

11. A device according to anyone of the preceding claims, wherein said sensitiser of the top cell unit is selected among dyes substantially not absorbing light above 700 nm, and having an absorption band with an absorption coefficient at λₘₐₓ of at least 5'000 1·cm⁻¹·M⁻¹ at wavelength ranges below 700 nm, and wherein said bottom cell unit is designed for absorbing at wavelengths above 700 nm.

12. A device according to claims 9 or 10, wherein said sensitising dye of the top cell unit is selected among dyes having a transparency window within the wavelength range 350 - 700 nm, between two absorption bands, and wherein said quantum dots of said bottom cell unit are selected among quantum dots capable of multiple carrier generation upon absorption of a photon having a wavelength within said transparency window.
